# EUROPÄISCHE PATENTSCHRIFT

(11) **EP 1 209 502 B1**
(45) Veröffentlichungstag und Bekanntmachung des Hinweises auf die Patenterteilung: **25.08.2004**
(21) Anmeldenummer: 01126635.0
(22) Anmeldetag: 08.11.2001
(51) Int. Cl.: G02B 7/02, G02B 7/08

(54) **Verfahren zur dynamischen Manipulation der Position einer Baugruppe in einem optischen System**
Method for the dynamic adjustment of the position of an element in an optical system
Méthode d'ajustage dynamique de position d'un élément dans un système optique

(30) Priorität: 16.11.2000 DE 10056782
(43) Veröffentlichungstag der Anmeldung: 29.05.2002
(73) Patentinhaber: Carl Zeiss SMT AG, 73447 Oberkochen (DE)
(72) Erfinder: Aubele, Karl-Eugen, 73312 Geislingen (DE)
(74) Vertreter: Lorenz, Werner, Dr.-Ing.

(56) Entgegenhaltungen:
- EP-A- 0 596 301
- US-A- 4 857 717
- US-A- 6 047 135

## Beschreibung

Die Erfindung betrifft ein Verfahren zur dynamischen Manipulation und/oder zur Justage der Position einer Baugruppe oder eines Bauelements in einem optischen System im Sub-µm-Bereich, insbesondere in einem Objektiv für die Halbleiter-Lithographie, nach der im Oberbegriff von Anspruch 1 näher definierten Art.

Zur Justage von Baugruppen oder Bauelementen in optischen Systemen im Sub-µm-Bereich kennt der allgemeine Stand der Technik lediglich sehr aufwendige Justagevorgänge, welche von erfahrenen Fachleuten "per Hand" ausgeführt werden müssen. Dazu dienen mit entsprechenden Über- bzw. Untersetzungen versehene Stellelemente, beispielsweise mit Schrauben-, Schneckengetrieben oder dergleichen.

Außerdem ist den Fachleuten bekannt, daß durch Erschütterungen bzw. Impulse, welche beispielsweise mittels eines kleinen Hammers auf die entsprechenden Bauelemente aufgebracht werden können, sehr feine Nachregulierungen der Bauelemente möglich sind.

In der DE 42 36 795 C1 ist eine entsprechende Vorrichtung zum Justieren von mechanischen Bauelementen beschrieben. Die zur Justage erforderliche Bewegung der Bauelemente, in diesem speziellen Fall handelt es sich dabei um einen Spiegel, wird über einen mechanischen Impulsgeber realisiert, welcher mittels eines Schlagstifts, in einer zu dem oben genannten Hammer vergleichbaren Art, auf die Halterung des zu justierenden Bauelements einen Impuls abgibt.

Auch dieser in der oben genannten Schrift beschriebene Aufbau ist vergleichsweise aufwendig, da er entsprechend hohe Kräfte benötigt, um die Bauelemente gegen deren Klemmung, welche diese durch Reibschluß festhalten sollen, verschieben zu könnnen.

Außerdem treten bei diesem Verfahren Erschütterungen in dem optischen System auf, welche sehr leicht zu einer Dejustage von Bauelementen in einem benachbarten Bereich führen können.

Als weiterer Nachteil der durch die oben genannte Schrift beschriebenen Vorrichtung muß sicherlich auch gesehen werden, daß durch die Erschütterungen zumindest zum Zeitpunkt des aufgebrachten Impulses die optische Qualität von gewünschten Abbildungen nicht sichergestellt werden kann. Die Vorrichtung eignet sich deshalb nicht für dynamische Manipulationen, also ein, im allgemeinen, geregeltes Nachstellen während des Betriebs des optischen Systems.

Eine an sich denkbare Manipulation oder Justage durch ein kontinuierliches Verstellen der Bauelemente ist im Sub-µm-Bereich jedoch auch nicht zu erreichen, da hier Effekte durch nicht zu vermeidende mechanische Rauhigkeiten und Ungenauigkeiten auftreten, welche zu gravierenden Problemen und unerwünschten Lageänderungen der Bauelemente führen. So hat beispielsweise die Erfahrung der Erfinder gezeigt, daß mit allen herkömmlichen Regelverfahren, welche mit proportionalen und/oder integralen und/oder differentiellen Regelanteilen operieren, keine befriedigenden Ergebnisse bei der Positionierung von Bauelementen in Genauigkeitsbereichen von wenigen Nanometern zu erreichen sind. Vermutlich beruht dies auf den bereits angesprochenen mechanischen Ungenauigkeiten, welche sich beispielsweise in Mikrorauhigkeiten, sehr ungleichmäßigen Slip-Stick-Effekten und geringfügigen Abweichungen der mechanischen Bauelemente, beispielsweise der Steifigkeiten von Festkörpergelenken oder dergleichen, äußern.

Es ist daher die Aufgabe der Erfindung, ein Verfahren zu schaffen, welches insbesondere die dynamische Manipulation der entsprechenden Bauelemente, aber auch die Justage der Bauelemente, ermöglicht, und welches mit sehr wenigen Verfahrensschritten in der Lage ist, die entsprechenden Bauelemente im Sub-µm-Bereich in eine ausreichend genaue Position zu bewegen.

Erfindungsgemäß wird diese Aufgabe durch die im kennzeichnenden Teil von Anspruch 1 genannten Verfahrensmerkmale gelöst.

Den Erfindern hat sich dabei in überraschender und nicht erwarteter Weise gezeigt, daß über die beiden hintereinander geschachtelten Verfahrensschritte, bei welchen die Aktuatoren das Geschwindigkeitsprofil abfahren und dann je nach ermittelter Ist-Position ein weiteres der Soll/Ist-Differenz angepaßtes Geschwindigkeitsprofil abfahren, eine sehr schnelle, also eine mit wenigen Wiederholungen dieser Schritte auskommende Positionierung der Bauelemente möglich ist.

Es hat sich in Versuchen gezeigt, daß eine Positionierung mit drei bis maximal fünf Verfahrensschritten durchaus realistisch ist, was den besonderen Vorteil bietet, daß dieses Verfahren sehr schnell ist und sich damit zu einer dynamischen Manipulation, also einer Nachregelung der Position der Baugruppen oder des Bauelements während des Betriebs des optischen Systems anbietet.

Im Gegensatz zu den eingangs genannten Problemen mit den herkömmlichen Regelungsverfahren (PID-Regler) wird durch das erfindungsgemäße Verfahren sowohl eine schnellere also auch eine bessere und zuverlässigere Manipulation der optischen Elemente erreicht.

Die bekannten Probleme bei der Positionierung in Sub-µm-Bereich, welche auf Mikrorauhigkeiten, Slip-Stick-Effekten und geringfügige Abweichungen der mechanischen Bauelemente, beispielsweise der Steifigkeiten von Festkörpergelenken oder dergleichen, beruhen, können durch das erfindungsgemäße Verfahren, welches praktisch eine iterative Annäherung der Ist-Position an die gewünschte Soll-Pposition des Bauelements oder der Baugruppe ermöglicht, in besonders günstiger Art und Weise kompensiert werden.

Grundlegend ist dabei anzumerken, daß zumindest der grobe Zusammenhang zwischen den vorgegebenen Sollwerten und dem durch die oben genannten Fehler niemals exakt zu erreichenden IstWert linear verlaufen sollte. Die reale Funktion des Zusammenhangs wird dabei sicherlich eine sehr "wilde" und unstetige Kurve sein, welche sich jedoch zumindest sehr grob durch den oben genannten linearen Zusammenhang annähern läßt. Sind die zu erzielenden Positionierungsschritte, welche über das veränderliche Geschwindigkeitsprofil, mit welchem die Aktuatoren angesteuert werden, erreicht werden, nun ausreichend groß, so werden sich die Werte entlang dieser vorgegebenen Steigung orientieren, so daß die einzelnen real erzielten Punkte auf der unstetigen Soll/Ist-Funktionskurve sich dem gewünschten Sollwert in der Art einer Iteration annähern.

In einer besonders günstigen Ausführungsform des oben genannten Verfahrens ist es dabei sehr günstig, wenn die Geschwindigkeitsprofile jeweils wenigstens eine von einer Startgeschwindigkeit ansteigende und eine auf eine Endgeschwindigkeit abfallende Geschwindigkeitsrampe aufweisen, deren Steigungen entsprechend dem noch zurückzulegenden, und im allgemeinen von Verfahrensschritt zu Verfahrensschritt immer kleiner werdenden Wegstück, angepaßt sind. Für sehr große Wegstücke kann dies eine vergleichsweise flach ansteigende Geschwindigkeitsrampe sein, an welche sich eine weitere flache oder gegebenenfalls auch konstante Geschwindigkeit anschließt, ehe über eine abfallende Geschwindigkeitsrampe die entsprechende Endgeschwindigkeit erreicht wird. Sind nur sehr kleine Positionierungsschritte nötig, so kann über eine sehr steile ansteigende und eine danach sofort wieder sehr steil abfallende Geschwindigkeitsrampe nur ein sehr kleiner Impuls auf die Aktuatoren gegeben werden, welcher dann entsprechend nur eine sehr kleine Bewegung bedingt.

Durch die Rampen werden dabei sehr sanfte Geschwindigkeitsänderungen erreicht, welche schnell und dennoch vergleichsweise frei von Erschütterungen ablaufen können.

Die Werte der Startgeschwindigkeit und der Endgeschwindigkeit können dabei gemäß einer besonderes günstigen Ausführungsform des Verfahrens jeweils Null sein, wodurch eine gegenüber einem schlagartigen Impuls sehr sanfte Bewegung der Aktuatoren und damit der Bauelemente erreicht wird.

Durch das oben genannte Verfahren hat sich in sehr günstiger Weise gezeigt, daß eine sehr schnelle, auch für eine dynamische Manipulation geeignete Anpassung der Ist-Position an die gewünschte Soll-Position der Baugruppe oder des Bauelements möglich ist, wobei, durch mechanische Ungenauigkeiten, durch Slip-Stick-Effekte, durch Mikrorauheiten und entsprechende Toleranzen bei den Aktuatoren, auftretende Fehler eliminiert werden.

Weitere vorteilhafte Ausgestaltungen der Erfindung ergeben sich aus den restlichen Unteransprüchen und dem anhand der Zeichnung nachfolgend dargestellten Ausführungsbeispiel.

Es zeigt:
- Figur 1: einen schematischen Plan eines Aufbaus zur Durchführung des Verfahrens;
- Figur 2: beispielhafte Geschwindigkeitsprofile gemäß dem Verfahren; und
- Figur 3: einen möglichen Ablauf des Verfahrens an einem ausgewählten Beispiel anhand eines Diagramms.

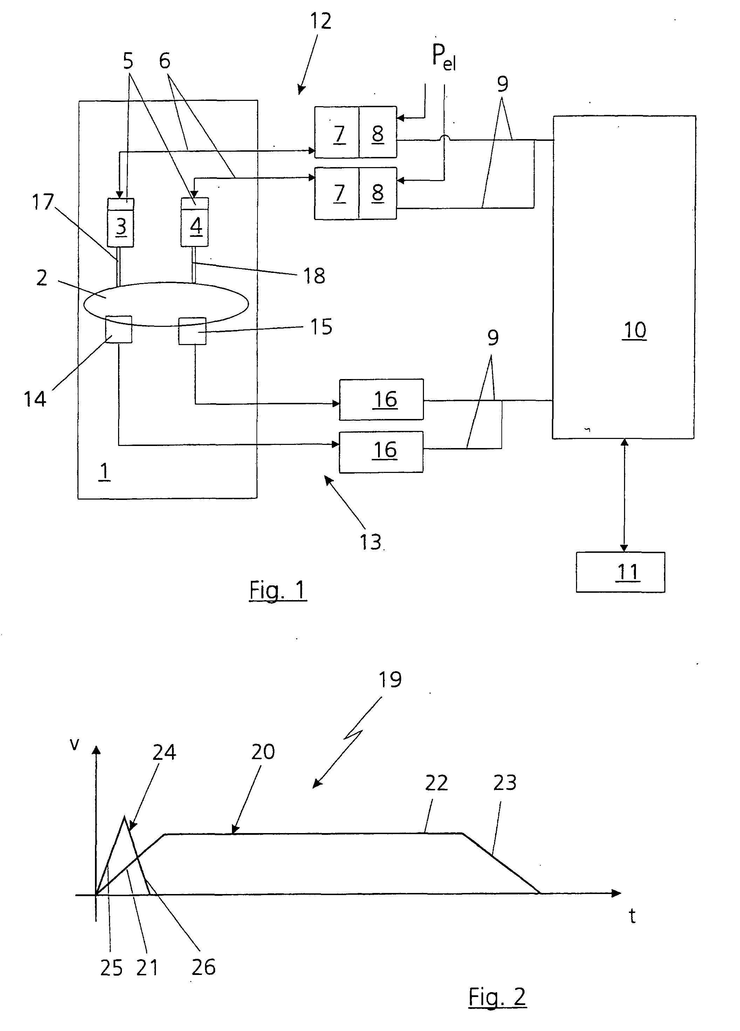

Fig. 1 zeigt eine prinzipmäßige Darstellung des optischen Systems 1 mit einer angedeuteten zu manipulierenden Baugruppe 2, hier einer Linse 2. Die Manipulation dieser Linse 2 soll dabei über zwei Aktuatoren 3, 4 erfolgen, welche beispielsweise elektromotorisch ausgebildet sein können.

Jeder der beiden Aktuatoren 3, 4 weist einen als Inkrementaldetektor ausgebildeten Detektor 5 auf, welcher Rückmeldungen über die erfolgte Bewegung oder zumindest die Relativbewegung der Aktuatoren 3, 4 liefert und welcher die Rückmeldungen über entsprechende Steuerungsleitungen 6 zu den jeweiligen Verstärkerelementen 7 bzw. der Motorregelung 8 weitergibt. Die Motorregelung stellt dabei über entsprechende Anschlußelemente auch die für den Betrieb der Aktuatoren 3, 4 erforderliche Leistung Pₑ₁ ins System und ist über weitere Leitungen 9, beispielsweise ein Bussystem 9, mit einer Datenverarbeitungseinheit 10, verbunden. Diese Datenverarbeitungseinheit 10 kann mit weiteren an sich bekannten externen Komponenten 11 in Verbindung stehen, durch welche Sollwerte vorgegeben werden können oder dergleichen.

Neben diesem eben beschriebenen Manipulationsstrang 12 weist der Aufbau einen Erfassungsstrang 13 auf, der ebenfalls über ein Bussystem bzw. dasselbe Bussystem 9 mit der Datenverarbeitungseinheit 10 verbunden ist. Grundlegend besteht dieser Erfassungsstrang 13 dabei aus zwei Sensoren 14, 15, welche zur Erfassung der Lage der Linse 2 in zwei verschiedenen Raumrichtungen ausgebildet sind, sowie weiteren elektronischen Baueinheiten, beispielsweise Verstärkern 16, Demodulationseinheiten oder dergleichen.

Gemäß dem eingangs beschriebenen Verfahren sind die Aktuatoren 3, 4 nun in der Lage die Linse 2 in verschiedenen Raumrichtungen zu bewegen, wobei hierzu prinzipmäßig angedeutete mechanische Übertragungselemente 17, 18 vorhanden sein können, welche beispielsweise als Hebelanordnungen oder dergleichen ausgebildet sind. Nachdem durch die Aktuatoren 3, 4 die Position der Linse 2 entsprechend manipuliert worden ist, wird durch die beiden Sensoren 14, 15 die genaue Position der Linse 2 erfaßt und an die Datenverarbeitungseinheit 10 zurückgemeldet. Ist die gewünschte Soll-Position noch nicht mit der durch die Sensoren 14, 15 gemessenen Ist-Position identisch, wird durch die Datenverarbeitungseinheit 10 eine weitere Bewegung der Linse 2 über die Aktuatoren 3, 4 ausgelöst, wobei sich diese Verfahrensschritte so lange wiederholen, bis die gewünschte Soll-Position zumindest im Rahmen von akzeptablen Toleranzen erreicht worden ist.

Fig. 2 zeigt nun ein Diagramm von Geschwindigkeitsprofilen 19, welches von den Aktuatoren 3 oder 4 beim Manipulieren der Linse 2 durchfahren wird. Im hier dargestellten Fall mit elektromotorisch wirkenden Aktuatoren 3,4 können solche Geschwindigkeitsprofile 19 beispielsweise durch ein korrespondierendes auf die Aktuatoren aufgeschaltetes Spannungsprofil vorgegeben werden. Bei andersartigen Aktuatoren, beispielsweise hydraulischen Aktuatoren, müßte ein entsprechendes Druckprofil erzeugt und auf den Aktuator geleitet werden. Grundlegend spielt dies für das genannte Verfahren jedoch keine Rolle, solange von den Aktuatoren 3,4 ein derartiges Geschwindigkeitsprofil 19 durchfahren wird.

Am Beispiel der in Fig. 2 dargestellten Kurven in einem Geschwindigkeits-Zeit-Diagramm sollen nun einige solche Geschwindigkeitsprofile 19 für verschiedene, beispielhaft gewählte Fälle veranschaulicht werden.

Ein erstes Geschwindigkeitsprofil 20 wird dabei gewählt, wenn eine sehr große Differenz zwischen der Soll-Position und der durch die Sensoren 14,15 ermittelten Ist-Position vorliegt. Das Geschwindigkeitsprofil 20 setzt sich dabei aus einer von einer Startgeschwindigkeit, hier 0, ansteigenden Geschwindigkeitsrampe 21, einer annähernd konstant verlaufenden Geschwindigkeit 22 zur Bewältigung des größten Teil des zu manipulierenden Wegs sowie einer danach auf eine Endgeschwindigkeit abfallenden Geschwindigkeitsrampe 23 zusammen. In diesem speziellen Ausführungsbeispiel sind dabei die Startgeschwindigkeit sowie die Endgeschwindigkeit jeweils 0. Sie könnten prinzipiell, insbesondere bei einer dynamischen Manipulation, jedoch auch bei durch eine vorherige Manipulation erreichten Endwerten bzw. Startwerten liegen, welche einerseits von 0 abweichend andererseits auch sehr unterschiedlich, also beispielsweise bei eine sehr große Startgeschwindigkeit und eine sehr kleine Endgeschwindigkeit, sein könnten.

Ein zweites Geschwindigkeitsprofil 24 setzt sich aus einer sehr viel steiler ansteigenden Rampe 25 und einer sofort im Anschluß daran abfallenden Rampe 26 zusammen. Ein derartiges Geschwindigkeitsprofil 24 ist beispielsweise dann geeignet, wenn die Linse 2 mittels der Aktuatoren 3, 4 ein sehr kurzes Wegstück zurücklegen soll.

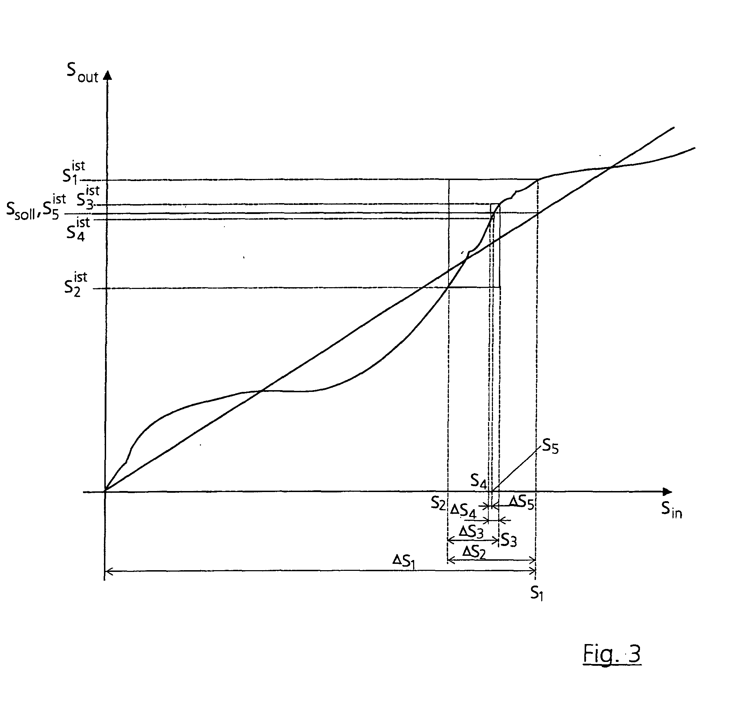

Fig. 3 soll nun anhand eines ausgewählten Beispiels ein Verfahren der iterativen Annäherung die gewünschte Sollposition näher erläutern. Grundlegend ist dabei davon auszugehen, daß die real existierenden Zusammenhänge zwischen dem durch die Datenverarbeitungseinheit 10 vorgegebenen Weg-Input sᵢₙ zu dem in dem System erzielten Weg-Output sₒᵤₜ zumindest im Bereich der hier zu manipulierenden Größenordnungen, welche bei Fahrwegen von wenigen Nanometern liegen, sicherlich nicht linear ist, sondern der hier beispielhaft dargestellten und für diesen Sonderfall stetigen Kurve 27 folgt.

Zumindest sehr grob läßt sich diese Kurve 27 jedoch durch die Ausgleichsgerade 28 annähern. Für die zu erzielende Soll-Position sₛₒₗₗ wird deshalb, der Ausgleichsgerade 28 folgend, über eine erste Manipulation mittels des Wegstücks Δs₁ die Position s₁ angefahren. Aufgrund der Kurve 27 wird diese Position s₁ jedoch nicht wie gewünscht bei sₛₒₗₗ liegen, sondern es wird die reale Position s₁^{ist} erreicht. Über den Erfassungsstrang 13 wird über die Sensoren 14, 15 ermittelt, daß die erreichte Position S₁ ist nicht der Soll-Position Sₛₒₗₗ entspricht. Über ein weiteres Geschwindigkeitsprofil 19 wird dann durch die Aktuatoren 3,4 der Korrekturweg Δs₂ angesteuert, welcher in dem hier vorliegenden Fall sehr viel kleiner als Δs₁ ist und, von dem Punkt s₁ ausgehend, negativ ausgebildet ist.

Nach Erreichen der Position s₂ wird wiederum festgestellt, daß die Ist-Position der Linse 2 nunmehr die Position s₂^{ist} ist. Auch diese Position s₂^{ist} weicht von der gewünschten Soll-Position sₛₒₗₗ ab und eine erneute Korrektur, um das Wegstück Δs₃ auf die Positon s₃, die gemäß der Kurve 27 wiederum der Position s₃^{ist} korrespondiert, wird durch die Datenverarbeitungseinheit 10 veranlaßt.

Die oben genannten Schritte wiederholen sich in dem hier dargestellten Ausführungsbeispiel so lange, bis mit der Position s₅^{ist} die Soll-Position sₛₒₗₗ erreicht ist.

Wie in dem Diagramm erkennbar ist, werden dabei aufgrund des wenigstens grob linearen Zusammenhang gehorchenden Funktion zwischen sᵢₙ und sₒᵤₜ die genannten Wegstücke Δs₁ bis Δs₅ jeweils kleiner und kehren jeweils ihre Vorzeichen um. Durch dieses iterative Annähern ist man dann in der Lage, mittels des in Fig. 1 dargestellten Aufbaus die gewünschte Soll-Position sₛₒₗₗ der Linse 2 sowohl für Justagezwecke als auch für eine dynamische Manipulation sehr schnell zu erreichen.

Das Verfahren erlaubt dabei eine Art "selbstlernenden" Betrieb, da sich die Iterationschritte mit zunehmenden Fortschreiten des Verfahrens verkleinern, was wiederum den zügigen Ablauf des Verfahrens weiter verbessert.

Über Speichermöglichkeiten in der Datenverarbeitungseinrichtung 10 ist man dazu außerdem in der Lage, den erfolgten Betrieb abzuspeichern und über die damit erhalten Werte die Auswahl des Startwertes für den nachfolgenden Betrieb zu optimieren. Auch auf diesem Wege lassen sich weitere Verbesserungen beim bezüglich des Manipulieren bzw. Justieren erreichen, insbesondere im Hinblick auf den zeitlichen Ablauf und die zu erzielende Positionsgenauigkeit.

## Patentansprüche

1. Verfahren zur dynamischen Manipulation und/oder zur Justage der Position einer Baugruppe (2) oder eines Bauelements in einem optischen System (1) im Sub-µm-Bereich, insbesondere in einem Objektiv für die Halbleiter-Lithographie, wobei die Baugruppe (2) oder das Bauelement durch wenigstens zwei Aktuatoren (3,4) die Detektoren (5) zur Ermittlung zumindest ihrer relativen Wegbewegungen aufweisen, bewegt wird, wobei die Position der Baugruppe 2 oder des Bauelements mit wenigstens zwei Sensoren 14,15 ermittelt wird, wobei die Sensoren und die Aktuatoren 3,4 mit ihren Detektoren 5 in der Art eines Regelkreises miteinander kommunizieren, und wobei durch die Aktuatoren 3,4 wenigstens ein mechanischer Impuls auf die Baugruppe oder das Bauelement ausgeübt wird, **dadurch gekennzeichnet, daß** der Impuls zeitlich gezielt veränderlich ist, wozu die Bewegung der Aktuatoren (3,4) mit einem abhängig von der ermittelten Position (sₙ^{ist}) gegenüber der Soll-Position (sₛₒₗₗ) der Baugruppe (2) oder des Bauelements vorgegebenen zeitlich veränderlichen Geschwindigkeitsprofil (19, 20,24) erfolgt, wobei nach Durchfahren des Geschwindigkeitsprofils (19,20,24) die Position (sₙ^{ist}) der Baugruppe (2) oder des Bauelements erneut ermittelt wird, und wobei die oben genannten Verfahrensschritte so lange wiederholt werden, bis die gewünschte Position (sₛₒₗₗ) der Baugruppe (2) oder des Bauelements erreicht ist.

2. Verfahren nach Anspruch 1, **dadurch gekennzeichnet, daß** das Geschwindigkeitsprofil (19,20,24) wenigstens eine von einer Startgeschwindigkeit ansteigende und eine auf eine Endgeschwindigkeit abfallende Geschwindigkeitsrampe (21,25;23, 26) aufweisen, deren Steigungen entsprechend dem noch zurückzulegenden Wegstück verändert werden.

3. Verfahren nach Anspruch 2, **dadurch gekennzeichnet, daß** die Startgeschwindigkeit und die Endgeschwindigkeit jeweils Null ist.

4. Verfahren nach Anspruch 1, 2 oder 3, **dadurch gekennzeichnet, daß** die Aktuatoren (3,4) jeweils über elektrische Motoren betrieben werden, wobei die Motoren zum Erzeugen des Geschwindigkeitsprofils (19,20,24) mit einem entsprechenden Spannungsprofil beaufschlagt werden.

5. Verfahren nach Anspruch 4, **dadurch gekennzeichnet, daß** die Bewegung der Motoren über jeweils wenigstens einen Detektor (5) als Inkrementaldetektor an jedem der Motoren überwacht wird.

6. Verfahren nach einem der Ansprüche 1 bis 5, **dadurch gekennzeichnet, daß** die Sensoren (14,15) als ein Erfassungsstrang (13) über Auswerteeinrichtungen, Verstärker (16) oder dergleichen mit einer elektronischen Datenverarbeitungseinheit (10) verbunden sind, und daß die Aktuatoren (3,4) mit ihren Detektoren (5) als Manipulationsstrang (12) ebenfalls über Auswerteeinrichtungen (8), Verstärker (7) oder dergleichen mit der elektronischen Datenverarbeitungseinheit (10) verbunden sind, durch welche der Verfahrensablauf gesteuert und/oder geregelt wird.

7. Verfahren nach Anspruch 6, **dadurch gekennzeichnet, daß** die Datenverarbeitungseinheit (10) über Speichermöglichkeiten verfügt, in welchen die bereits durchfahrenen Geschwindigkeitsprofile (19) in Abhängigkeit der Soll-/Ist-Positionen abgespeichert werden, wobei diese Speicherdaten zur Beeinflussung der nachfolgenden Geschwindigkeitsprofile (19) herangezogen werden.

## Claims

1. Method for dynamically manipulating and/or adjusting the position of a module (2) or a component in an optical system (1) in the sub-µm range, especially in an objective for semiconductor lithography, the module (2) or the component being moved by at least two actuators (3, 4) which have detectors (5) for determining at least their relative displacement movements, the position of the module (2) or of the component being determined by at least two sensors (14, 15), the sensors and the actuators (3, 4) with their detectors (5) communicating with one another in the manner of a control loop, and at least one mechanical impulse being imparted to the module or the component by the actuators (3, 4), **characterised in that** the impulse can be varied in a controlled way as a function of time, for which purpose the actuators (3, 4) are moved with a predetermined time-variable velocity profile (19, 20, 24) depending on the determined position (sₙ^{actual}) with respect to the setpoint position (sₛₑₜ) of the module (2) or of the component, the position (sₙ^{actual}) of the module (2) or of the component being determined again after the velocity profile (19, 20, 24) has been executed, and the aforementioned method steps being repeated until the intended position (sₛₑₜ) of the module (2) or of the component is reached.

2. Method according to Claim 1, **characterised in that** the velocity profile (19, 20, 24.) has at least one velocity ramp rising from a start velocity and one velocity ramp falling to a final velocity, (21, 25; 23, 26). the gradients of which are varied according to the displacement interval remaining to be covered.

3. Method according to Claim 2, **characterised in that** the start velocity and the final velocity are each zero.

4. Method according to Claim 1, 2 or 3, **characterised in that** the actuators (3, 4) are each operated using electric motors, an appropriate voltage profile being applied to the motors in order to generate the velocity profile (19, 20, 24).

5. Method according to Claim 4, **characterised in that** the movement of the motors is respectively monitored using at least one detector (5) as an incremental detector on each of the motors.

6. Method according to one of Claims 1 to 5,
**characterised in that** the sensors (14, 15) are connected to an electronic data processing unit (10) via evaluation instruments, amplifiers (16) or the like as an acquisition branch (13), and **in that** the actuators (3, 4) with their detectors (5) are connected as a manipulation branch (12), likewise via evaluation instruments (8), amplifiers (7) or the like, to the electronic data-processing unit (10) by which the conduct of the method is controlled and/or regulated.

7. Method according to Claim 6, **characterised in that** the data-processing unit (10) has storage facilities in which the velocity profiles (19) already executed are stored as a function of the setpoint/actual positions, these stored data are being employed in order to modify the subsequent velocity profiles (19).

## Revendications

1. Procédé de manipulation dynamique et/ou d'ajustement de la position d'un sous-ensemble (2) ou d'un composant dans un système optique (1) dans le domaine sub-micrométrique, notamment dans un objectif pour la lithographie de semi-conducteurs, dans lequel le sous-ensemble (2) ou le composant est déplacé à l'aide d'au moins deux actionneurs (3, 4) qui comprennent des détecteurs (5) pour la détermination d'au moins leurs mouvements relatifs, dans lequel la position du sous-ensemble (2) ou du composant est déterminée à l'aide d'au moins deux capteurs (14, 15), dans lequel les capteurs et les actionneurs (3, 4) communiquent avec leurs détecteurs (5) à la manière d'un circuit de régulation, et dans lequel, grâce aux actionneurs (3, 4), au moins une impulsion mécanique est appliquée sur le sous-ensemble ou le composant, **caractérisé en ce que** l'impulsion est variable dans le temps de manière ciblée, le déplacement des actionneurs (3, 4) étant effectué avec un profil de vitesse (19, 20, 24) prédéterminé et variable dans le temps en fonction de la position (Sₙ^{ist}) déterminée par rapport à la position de consigne (Sₛₒₗₗ), la position (Sₙ^{ist}) du sous-ensemble (2) ou du composant étant déterminée à nouveau après avoir parcouru le profil de vitesse (19, 20, 24), et les étapes du procédé mentionnées ci-dessus étant répétées jusqu'à ce que la position souhaitée (Sₛₒₗₗ) du sous-ensemble (2) ou du composant soit atteinte.

2. Procédé selon la revendication 1, **caractérisé en ce que** le profil de vitesse 19, 20, 24) comprend au moins une rampe de vitesse (21, 25; 23, 26) montant à partir d'une vitesse initiale et diminuant vers une vitesse finale, dont les pentes changent en fonction du trajet restant à effectuer.

3. Procédé selon la revendication 2, **caractérisé en ce que** la vitesse initiale et la vitesse finale sont nulles.

4. Procédé selon la revendication 1, 2 ou 3, **caractérisé en ce que** les actionneurs (3, 4) sont entraînés par l'intermédiaire de moteurs électriques, les moteurs étant alimentés avec un profil de tension approprié pour générer le profil de vitesse (19, 20, 24).

5. Procédé selon la revendication 4, **caractérisé en ce que** le mouvement des moteurs est surveillé sur chacun des moteurs par l'intermédiaire d'un détecteur (5), qui est un détecteur incrémental.

6. Procédé selon l'une des revendications 1 à 5, **caractérisé en ce que** les capteurs (14, 15) sont reliés, en tant que chaîne de détection (13), par l'intermédiaire de dispositifs d'analyse, d'amplificateurs (16) ou autres, avec une unité électronique de traitement des données (10) et **en ce que** les actionneurs (3, 4), avec leurs détecteurs (5) sont reliés, en tant que chaîne de manipulation (12), également par l'intermédiaire de dispositifs d'analyse (8), d'amplificateurs (7) ou autres, avec l'unité électronique de traitement des données (10), grâce à laquelle le déroulement du procédé est contrôlé et/ou régulé.

7. Procédé selon la revendication 6, **caractérisé en ce que** l'unité de traitement des données (10) dispose de possibilités d'enregistrement dans lesquels les profils de vitesse (19) déjà parcourus sont enregistrés en fonction des positions réelles/de consigne, ces données enregistrées étant utilisées pour influencer les profils de vitesses (19) suivants.
